# EUROPEAN PATENT APPLICATION

(11) **EP 4 400 249 A1**
(43) Date of publication of application: **17.07.2024**
(21) Application number: 23212462.8
(22) Date of filing: 27.11.2023
(51) Int. Cl.: B23K 26/26, H01M 10/42, H01M 50/507, H01M 50/516, H01M 50/519, H01M 50/522

(54) **RECHARGEABLE BATTERY MODULE**

(30) Priority: 16.01.2023 KR 20230006358
(71) Applicant: Samsung SDI Co., Ltd., Yongin-si, Gyeonggi-do 17084 (KR)
(72) Inventor: KWON, Young-Hwan, 17084 Yongin-si (KR); LEE, Hyeok, 17084 Yongin-si (KR)
(74) Representative: Marks & Clerk LLP

(57) **Abstract**

An embodiment provides a rechargeable battery module including: a plurality of battery cells stacked in a first direction; a bus bar holder covering the battery cells while exposing electrode terminals of the battery cells in a third direction crossing a second direction at both sides in the second direction crossing the first direction; a bus bar connecting the exposed electrode terminals to a bus bar support portion of the bus bar holder; a flexible printed circuit (FPC) disposed on the bus bar on one surface of a copper foil exposed in the third direction; an aluminium tab disposed on the other surface of the copper foil; and a welding portion formed by the bus bar, the copper foil, and the aluminium tab that are laser welded.

## Description

### BACKGROUND

### (a) Technical Field

The present disclosure relates to a rechargeable battery module.

### (b) Description of the Related Art

A rechargeable battery is a battery that is repeatedly charged and discharged, unlike a primary battery. A small-capacity rechargeable battery is used in a portable small electronic device such as a mobile phone, a laptop computer, and a camcorder.

A large-capacity and high-density rechargeable battery is used for a power source or energy storage for driving a motor of a hybrid vehicle and an electric vehicle. The rechargeable battery may be used as a rechargeable battery module including a plurality of battery cells connected in series and/or in parallel to be able to drive a motor of a hybrid vehicle, as an example, that requires a relatively high energy density.

For example, the rechargeable battery module uses an intermediate medium made of a nickel tab to connect a flexible printed circuit (FPC) and a bus bar made of aluminium or copper to measure a cell voltage.

In a case of using the nickel tab as the intermediate medium, one end of the nickel tab is connected to the flexible printed circuit by a soldering method, and the other end of the nickel tab is connected to the bus bar by a laser welding method. The method of using the nickel tab increases the price of raw materials and reduces the cost competitiveness of the rechargeable battery module.

### SUMMARY OF THE INVENTION

The present disclosure relates to a rechargeable battery module that may directly laser-weld a bus bar and a sensing flexible printed circuit (FPC)

An embodiment is to provide a rechargeable battery module that may improve cost competitiveness by removing expensive nickel tabs by directly welding a flexible printed circuit (FPC) and a bus bar and reducing the process cost.

An embodiment of the present disclosure is to provide a rechargeable battery module that may prevent cost increase by using a flexible printed circuit (FPC) of 1 ounce (1 oz = 35 µm) of copper foil, which is most commonly used for general purposes.

An embodiment of the present disclosure is to provide a rechargeable battery module that may directly laser-weld a flexible printed circuit that utilizes a general-purpose copper foil to an aluminium bus bar and that may secure stable welding strength.

An embodiment provides a rechargeable battery module including: a plurality of battery cells stacked in a first direction; a bus bar holder covering the battery cells while exposing electrode terminals of the battery cells in a third direction crossing a second direction at both sides in the second direction crossing the first direction; a bus bar connecting the exposed electrode terminals to a bus bar support portion of the bus bar holder; a flexible printed circuit (FPC) disposed on the bus bar on one surface of a copper foil exposed in the third direction; an aluminium tab disposed on the other surface of the copper foil; and a welding portion formed by the bus bar, the copper foil, and the aluminium tab that are laser welded.

The copper foil may have a thickness of 35 µm. The aluminium tab may have a thickness of 0.1 to 0.2 mm.

The flexible printed circuit may include a signal line transmitting a sensing signal, a connection line connecting the copper foil to the signal line, a coating layer covering the signal line, the copper foil, and the connection line, and a slot hole that surrounds an outer periphery of the copper foil and penetrates the coating layer to have both ends on both sides in a width direction of the connection line.

The signal line may be formed from one side of a width direction of the flexible printed circuit in a length direction of the flexible printed circuit, while the copper foil may be formed as a predetermined area on the other side of the width direction of the flexible printed circuit.

The connection line may be formed in the width direction to connect the signal line and the copper foil.

The coating layer may form a neck portion between the slot holes on both sides of the connection line in the length direction.

A width of the neck portion set in the length direction may be set smaller than an entire length of the slot hole set in the length direction and larger than the width of the connecting line.

The bus bar may include a terminal connection portion connecting electrode terminals of battery cells adjacent in the first direction, and a sensing portion protruding in the second direction from one side of the terminal connection portion to be connected to the copper foil.

The sensing portion may have an area (L1 *L2) of a first length (L1) in the first direction and a second length (L2) in the second direction, and may support an entire area of the copper foil, the slot hole, the connection line, and a part of the signal line.

The welding portion may form a structure in which aluminium of the bus bar, copper of the copper foil, and aluminium of the aluminium tab are mixed.

The copper foil may include a nickel (Ni) plating section and a gold (Au) plating section. The welding portion may form a structure in which nickel (Ni) and gold (Au) are further mixed.

The welding portion may be formed with an output of 1 kW or less by the laser welding.

When an output of the laser welding is 180 W, a thickness of the copper foil is 35 µm, and a thickness of the aluminium tab is 0.2 mm, the welding portion may include 90.4 wt% of aluminium, 0.8 wt% of nickel, 4.4 wt% of copper, and 4.4 wt% of oxygen.

When an output of the laser welding is 210 W, a thickness of the copper foil is 35 µm, and a thickness of the aluminium tab is 0.2 mm, the welding portion may include 87.9 wt% of aluminium, 1.8 wt% of nickel, 7.4 wt% of copper, and 2.9 wt% of oxygen.

When an output of the laser welding is 240 W, a thickness of the copper foil is 35 µm, and a thickness of the aluminium tab is 0.2 mm, the welding portion may include 70.3 wt% of aluminium, 5.2 wt% of nickel, 22.2 wt% of copper, and 2.3 wt% of oxygen.

The welding portion may include 70.3 to 90.4 wt% of aluminium, 0.8 to 5.2 wt% of nickel, 4.4 to 22.2 wt% of copper, and 2.3 to 4.4 wt% of oxygen.

At least some of the above and other features of the invention are set out in the claims.

The rechargeable battery module according to the embodiment, by disposing a copper foil of a flexible printed circuit (FPC) on a bus bar and further providing an aluminium tab on the copper foil to form a welded portion by laser welding, may directly weld the flexible printed circuit to the bus bar. Accordingly, since expensive nickel tabs are removed and process prices are lowered, cost competition may be improved.

According to the embodiment, because a general-purpose flexible printed circuit (FPC) with a 1 oz copper foil (1 oz = 35 µm) is used, laser welding may be directly performed on an aluminium bus bar, and cost increases while securing stable welding strength may be prevented.

### BRIEF DESCRIPTION OF THE DRAWINGS

FIG. 1 illustrates an exploded perspective view of a rechargeable battery module according to an embodiment of the present disclosure.
FIG. 2 illustrates a partial perspective view of FIG. 1.
FIG. 3 illustrates a top plan view of a flexible printed circuit applied in FIG. 2.
FIG. 4 illustrates a top plan view of a state in which a flexible printed circuit and an aluminium tab are disposed on a bus bar.
FIG. 5 illustrates an exploded perspective view of the bus bar, the flexible printed circuit, and the aluminium tab shown in FIG. 4.
FIG. 6 illustrates a cross-sectional view taken along line VI-VI of FIG. 5.
FIG. 7 illustrates a top plan view of Comparative Example 1.
FIG. 8 illustrates a cross-sectional view taken along line VIII-VIII of FIG. 7.
FIG. 9 illustrates a planar image of a result of Comparative Example 1 of FIG. 7 and FIG. 8.
FIG. 10a and FIG. 10b illustrate images of a welded portion of a copper foil and a bus bar according to Comparative Example 2.
FIG. 11a and FIG. 11b illustrate images of a welded portion of a copper foil and a bus bar according to Comparative Example 3.
FIG. 12a and FIG. 12b illustrate images of a welded portion of a copper foil and a bus bar according to Comparative Example 4.
FIG. 13a and FIG. 13b illustrate images of a welded portion of a copper foil and a bus bar according to Comparative Example 5.
FIG. 14a and FIG. 14b illustrate images of a welded portion of a copper foil and a bus bar according to Comparative Example 6.
FIG. 15a and FIG. 15b illustrate images of a welded portion of a copper foil and a bus bar according to Comparative Example 7.
FIG. 16 illustrates a cross-sectional image of an experimental example of the present disclosure before welding.
FIG. 17 illustrates a cross-sectional image of a state after welding of FIG. 16.

### DETAILED DESCRIPTION OF THE EMBODIMENTS

The present disclosure will be described more fully hereinafter with reference to the accompanying drawings, in which embodiments of the invention are shown. As those skilled in the art would realize, the described embodiments may be modified in various different ways, all without departing from the scope of the present disclosure. The drawings and description are to be regarded as illustrative in nature and not restrictive. Like reference numerals designate like elements throughout the specification.

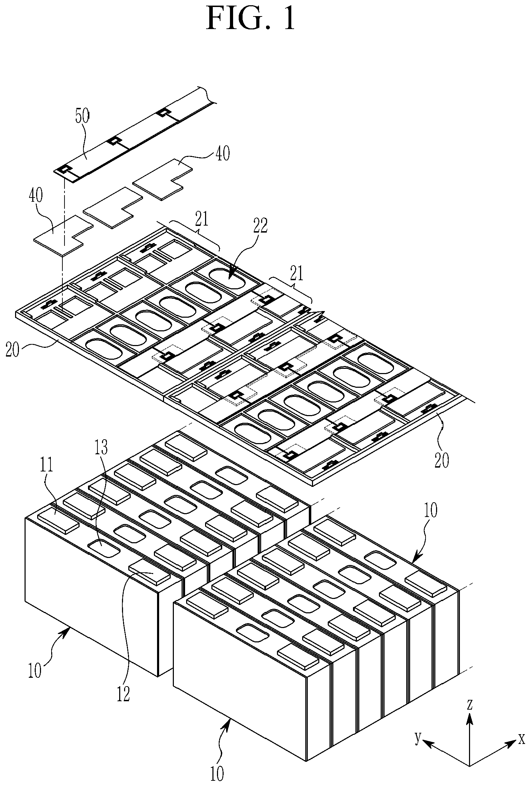

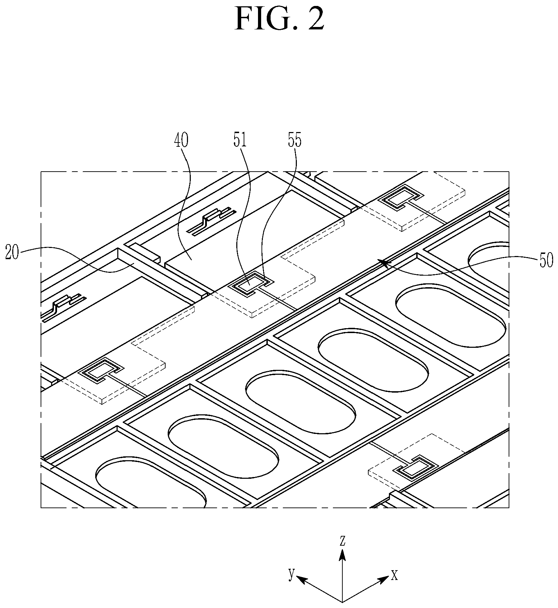

FIG. 1 illustrates an exploded perspective view of a rechargeable battery module according to an embodiment of the present disclosure, and FIG. 2 illustrates a partial perspective view of FIG. 1.

Referring to FIG. 1 and FIG. 2, a rechargeable battery module of an embodiment includes a plurality of battery cells 10, a bus bar holder 20, a bus bar 40, a flexible printed circuit (FPC) 50, an aluminium tab 60, and a welding portion 70.

The flexible printed circuit 50, which is used for general purpose, includes a copper foil 51, and a thickness of the copper foil 51 is 35 µm, equivalent to 1 oz. The copper foil 51 of more than 1 ounce is not widely used because it significantly increases the cost of the flexible printed circuit 50.

In terms of welding characteristics, when a thickness of the copper foil 51 is 100 µm, it has excellent welding characteristics, but when the thickness of the copper foil 51 is less than 100 µm, the welding strength is low and laser welding is not easy. In the embodiment, stable welding strength may be realized even in the flexible printed circuit 50 using the copper foil 51 having a thickness of 35 µm, which is used for general purposes.

The rechargeable battery module according to the embodiment may have frames having various structures, but a detailed description of these structures will be omitted, and a structure including main portions of the present disclosure will be described.

The plurality of battery cells 10 are formed as rechargeable batteries and are stacked in a first direction (x-axis direction). A pair of end plates are disposed at both ends of the stacked battery cells 10 in the first direction to set constraints on the battery cells 10 in the first direction (x-axis direction).

A pair of side plates are disposed at both sides of the battery cells 10 in a second direction (y-axis direction) crossing the first direction and are connected to the pair of end plates to set constraints on the battery cells 10 in the second direction.

The bus bar holder 20 includes a bus bar support portion 21 for connecting and insulating electrode terminals 11 and 12 of the battery cells 10 and a vent portion 22 for discharging vent gas from the battery cells 10.

The bus bar support portion 21 covers the battery cells 10 while exposing the electrode terminals 11 and 12 in a third direction (cell height, z-axis direction). The third direction (cell height, z-axis direction) crosses the first direction (cell thickness, x-axis direction) and the second direction (cell length, y-axis direction).

The bus bar 40 is welded to the electrode terminals 11 and 12 exposed in the third direction through the bus bar support portion 21 to electrically and mechanically connect the electrode terminals 11 and 12. That is, the bus bar 40 connects the electrode terminals 11 and 12 of the battery cells 10 adjacent to each other in the first direction in parallel or in series.

The vent portion 22 corresponds to vents 13 of the battery cells 10 to discharge opening pressure and ejected materials of the battery cells 10 to the outside of the bus bar holder 20 when the vents 13 are opened. The bus bar support portions 21 corresponding to the electrode terminals 11 and 12 in the second direction (cell length, y-axis direction) are disposed on both sides, and the vent portion 22 corresponding to the vent 13 provided between the electrode terminals 11 and 12 is disposed between the bus bar support portions 21.

The flexible printed circuit 50 is disposed on the bus bar 40 with one surface of the copper foil 51 exposed in the third direction (z-axis). The aluminium tab 60 is disposed on the other surface of the copper foil portion 51 and laser welded (LW). The welding portion 70 is formed of the bus bar 40, the copper foil 51, and the aluminium tab 60 subjected to laser welding (LW) by laser welding (LW).

For example, the copper foil 51 has a thickness of 1 ounce (oz, 35 µm) applied to the general-purpose flexible printed circuit 50. The aluminium tab 60 may have a thickness of 0.1 to 0.2 mm.

When the thickness of the aluminium tab 60 is less than 0.1 mm, it is difficult to secure the strength of the welded portion 70. When the thickness of the aluminium tab 60 exceeds 0.2 mm, it is difficult to form the welding portion 70 with the aluminium tab 60 due to melting vaporization of the copper foil 51 while requiring an excessively high laser power.

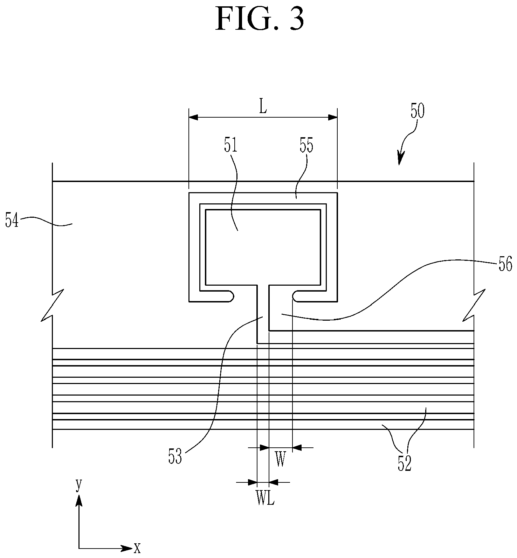

FIG. 3 illustrates a top plan view of a flexible printed circuit applied in FIG. 2. Referring to FIG. 3, the flexible printed circuit 50 includes a signal line 52 for transmitting a sensing signal, a connection line 53, a coating layer 54, and a slot hole 55.

The connection line 53 connects the copper foil 51 to the signal line 52. The copper foil 51 is connected to the bus bar 40 by the welding portion 70 to detect the battery cell 10 connected to the bus bar 40 to transmit the detected signal to the connection line 53 and the signal line 52.

The coating layer 54 coats the signal line 52, the copper foil 51, and the connection line 53 to form the flexible printed circuit 50. As an example, the coating layer 54 is formed of polyimide and coated with an adhesive. The slot hole 55 surrounds the outer periphery of the copper foil 51 and penetrates the coating layer 54 to have both ends on both sides of the connection line 53 in the width direction.

The signal line 52 is formed in the length direction of the flexible printed circuit 50 at one side of the flexible printed circuit 50 in the width direction (y-axis direction). The copper foil 51 is formed to have a predetermined area at the other side of the flexible printed circuit 50 in the width direction (y-axis direction). The connection line 53 is formed in the width direction (y-axis direction) to connect the signal line 52 and the copper foil 51.

The coating layer 54 forms a neck portion 56 between the slot holes 55 on both sides of the connection line 53 in the length direction (x-axis direction). A width (W) of the neck portion 56 set in the length direction (x-axis direction) is smaller than a total length (L) of the slot hole 55 set in the length direction and larger than a width (WL) of the connection line 53.

Although the integrity of the copper foil 51 and the signal line 52 is weakened due to the slot hole 55, the width (W) of the neck portion 56 maintains the solid strength of the connection line 53, and it also allows the flow of the battery cell 10 to be absorbed into the slot hole 55.

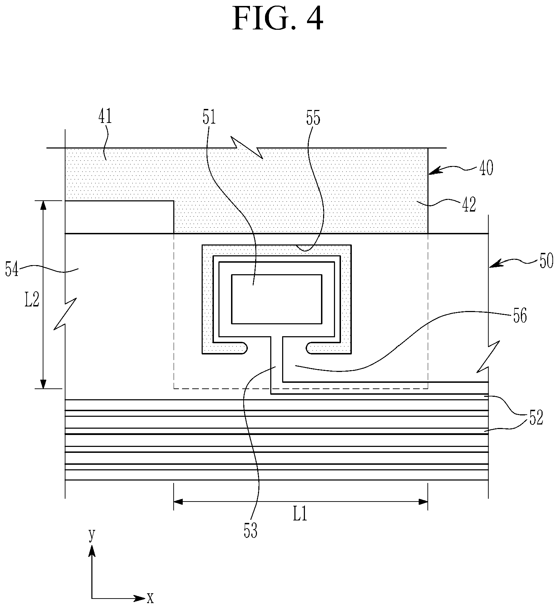

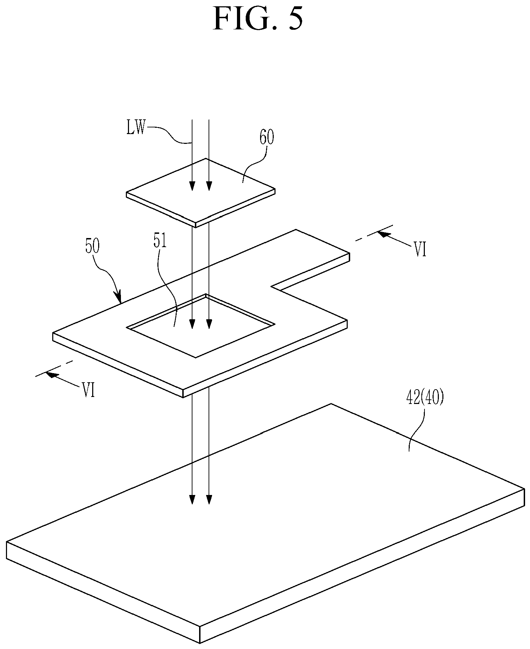

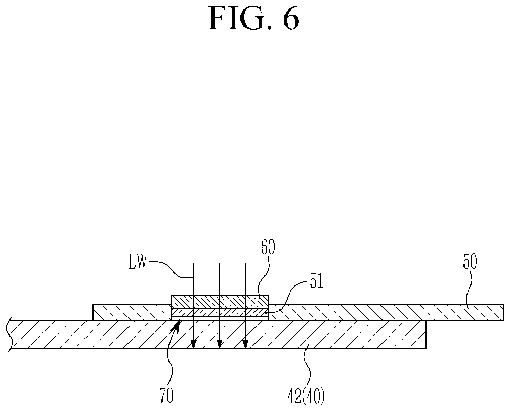

FIG. 4 illustrates a top plan view of a state in which a flexible printed circuit and an aluminium tab are disposed on a bus bar, FIG. 5 illustrates an exploded perspective view of the bus bar, the flexible printed circuit, and the aluminium tab shown in FIG. 4, and FIG. 6 illustrates a cross-sectional view taken along line VI-VI of FIG. 5.

Referring to FIG. 4 to FIG. 6, the bus bar 40 includes a terminal connection portion 41 and a sensing portion 42. The bus bar 40 may include aluminium. The terminal connection portion 41 connects the electrode terminals 11 and 12 of the battery cells 10 adjacent to each other in the first direction (x-axis direction). The sensing portion 42 protrudes from one side of the terminal connection portion 41 in the second direction (y-axis direction) to be connected to the copper foil 51.

The sensing portion 42 has an area (L1*L2) of a first length L1 in the first direction (x-axis direction) and a second length L2 in the second direction (y-axis direction). The entire area of the copper foil 51, the slot hole 55, the connection line 53, and a portion of the signal line 52 are supported.

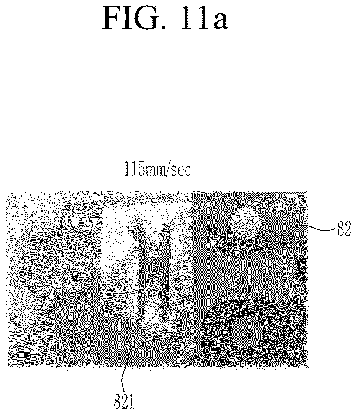

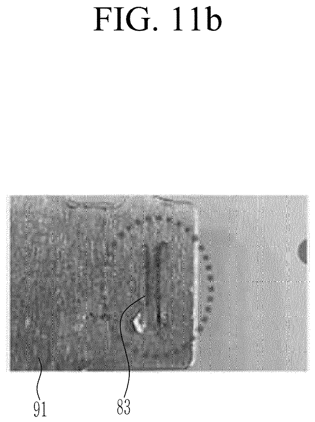

The welding portion 70 forms a structure in which the aluminium component of the bus bar 40, the copper component of the copper foil 51, and the aluminium component of the aluminium tab 60 are mixed (see FIG. 11). Therefore, the welding portion 70 may weld the copper foil 51 and the bus bar 40 with sufficient strength.

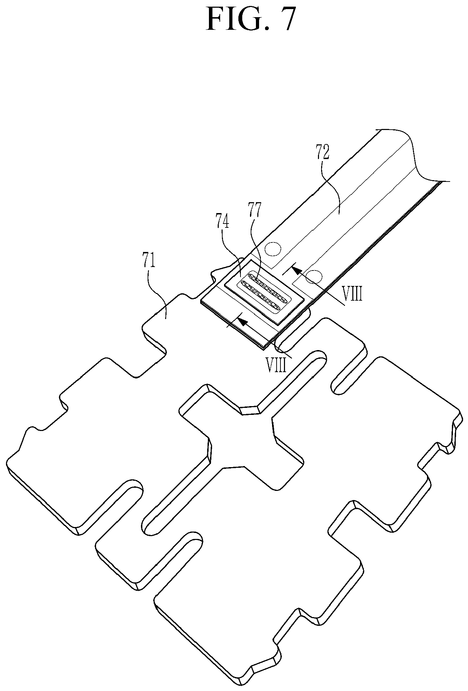

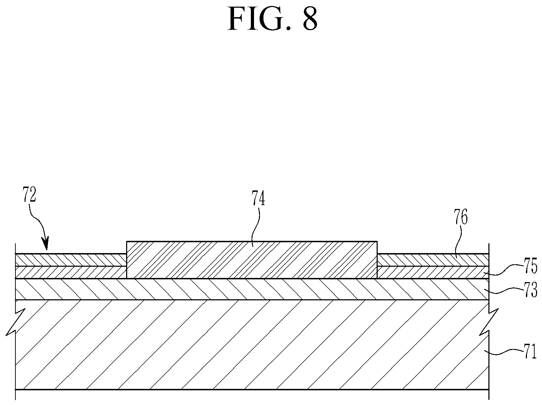

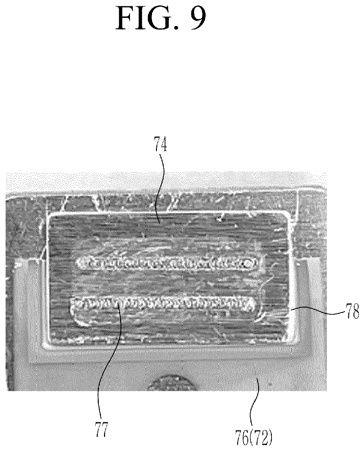

FIG. 7 illustrates a top plan view of Comparative Example 1, FIG. 8 illustrates a cross-sectional view taken along line VIII-VIII of FIG. 7, and FIG. 9 illustrates a planar image of a result of Comparative Example 1 of FIG. 7 and FIG. 8.

Referring to FIG. 7 to FIG. 9, in Comparative Example 1, the copper foil 73 of the flexible printed circuit 72 is disposed on the aluminium bus bar 71, and an aluminium tab 74 is disposed on a copper foil 73 exposed in a coating layer 76 attached with an adhesive layer 75 and laser welded with a two-line bead 77.

When the bus bar 71 and the flexible printed circuit 72 are stretched, and when it is seen that the coating layer 76 of the flexible printed circuit 72 is first broken (78), it can be seen that weldability of the aluminium bus bar 71, the copper foil 73, and the aluminium tab 74 is excellent, while rigidity of the flexible printed circuit 72 is insufficient.

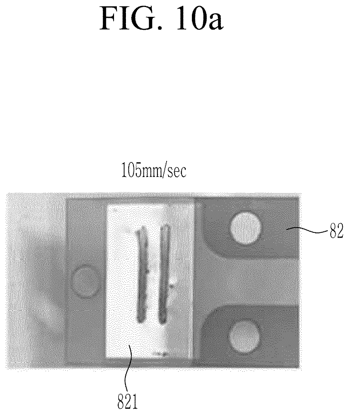

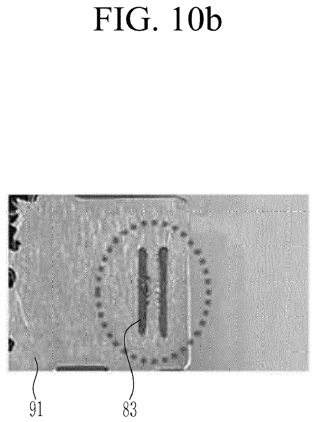

FIG. 10a and FIG. 10b illustrate images of a welded portion of a copper foil and a bus bar according to Comparative Example 2. Referring to FIG. 10a and FIG. 10b, in Comparative Example 2, the copper foil 821 of the flexible printed circuit 82 was disposed on the aluminium bus bar 91, and laser welding was performed on the copper foil 821 as two-line beads 83. A thickness of the copper foil 821 was 1 ounce (oz, 35 µm), and the laser welding was performed at a welding speed of 105 mm/sec without applying an aluminium tab. A welding defect occurred in the bus bar 91.

FIG. 11a and FIG. 11b illustrate images of a welded portion of a copper foil and a bus bar according to Comparative Example 3. Referring to FIG. 11a and FIG. 11b, in Comparative Example 3, the thickness of the copper foil 821 was 1 oz, and the laser welding was performed at a welding speed of 115 mm/sec without applying an aluminium tab. A welding defect occurred in the bus bar 91.

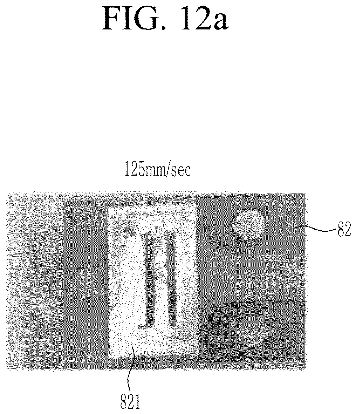

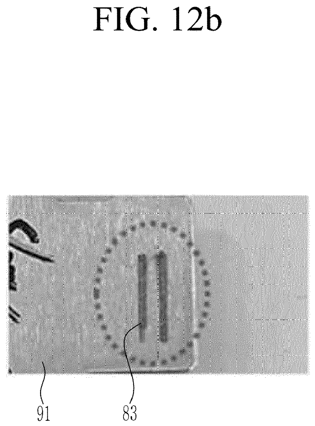

FIG. 12a and FIG. 12b illustrate images of a welded portion of a copper foil and a bus bar according to Comparative Example 4. Referring to FIG. 12a and FIG. 12b, in Comparative Example 4, the thickness of the copper foil 821 was 1 oz, and the laser welding was performed at a welding speed of 125 mm/sec without applying an aluminium tab. A welding defect occurred in the bus bar 91.

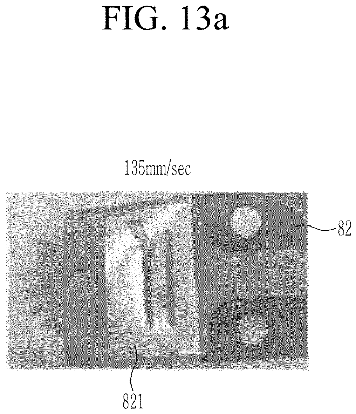

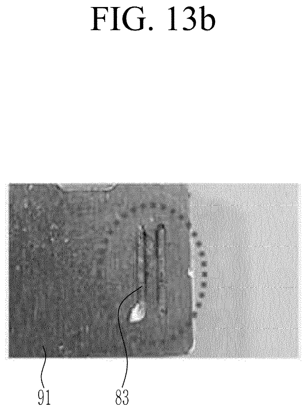

FIG. 13a and FIG. 13b illustrate images of a welded portion of a copper foil and a bus bar according to Comparative Example 5. Referring to FIG. 13a and FIG. 13b, in Comparative Example 5, the thickness of the copper foil 821 was 1 oz, and the laser welding was performed at a welding speed of 135 mm/sec without applying an aluminium tab. A welding defect occurred in the bus bar 91.

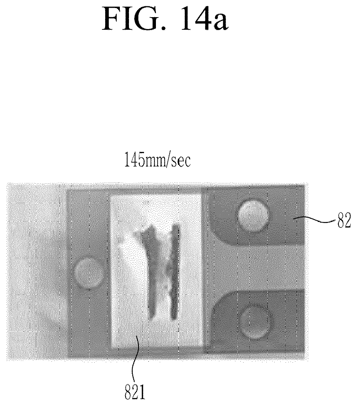

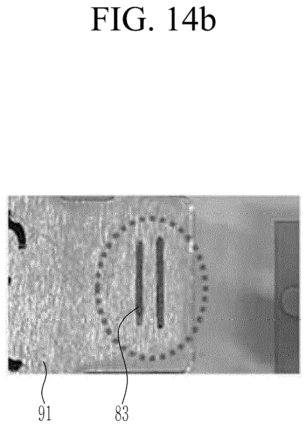

FIG. 14a and FIG. 14b illustrate images of a welded portion of a copper foil and a bus bar according to Comparative Example 6. Referring to FIG. 14a and FIG. 14b, in Comparative Example 5, the thickness of the copper foil 821 was 1 oz, and the laser welding was performed at a welding speed of 145 mm/sec without applying an aluminium tab. A welding defect occurred in the bus bar 91.

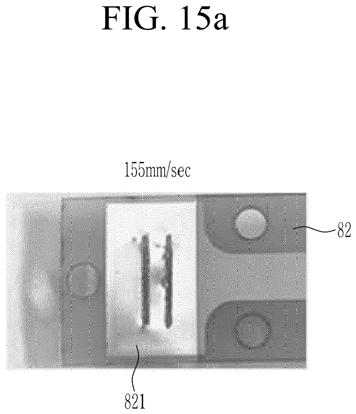

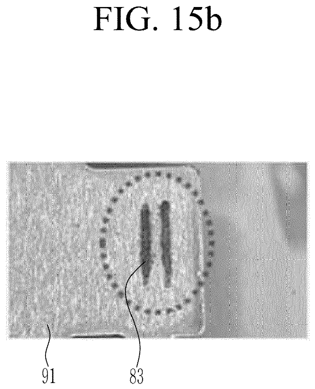

FIG. 15a and FIG. 15b illustrate images of a welded portion of a copper foil and a bus bar according to Comparative Example 7. Referring to FIG. 15a and FIG. 15b, in Comparative Example 7, the thickness of the copper foil 821 was 1 oz, and the laser welding was performed at a welding speed of 155 mm/sec without applying an aluminium tab. A welding defect occurred in the bus bar 91.

Referring to the welding defects that were the result of Comparative Examples 1 to 7 of FIG. 10a to FIG. 15b, it was found to be impossible to weld the copper foil 821 having a thickness of 35 µm to the aluminium bus bar 91 without applying an aluminium tab. Even though the welding speed was varied, welding was impossible.

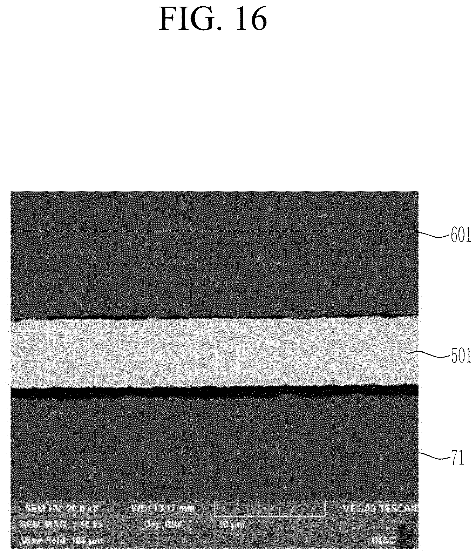

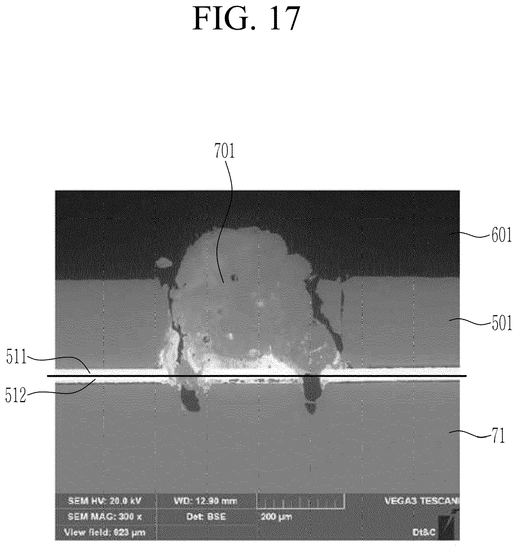

FIG. 16 illustrates a cross-sectional image of an experimental example of the present disclosure before welding, and FIG. 17 illustrates a cross-sectional image of a state after welding of FIG. 16.

Referring to FIG. 16 and FIG. 17, in the experimental example, the copper foil 501 further includes a nickel (Ni) plating section 511 and a gold (Au) plating section 512 stacked in the thickness direction.

A stacked structure of the nickel (Ni) plating section 511 and the gold (Au) plating section 512 may be formed on lower and upper surfaces of the copper foil 501. When the copper foil 501 of the flexible printed circuit is disposed on the aluminium bus bar 71, the aluminium tab 601 is disposed on the copper foil 501, and laser welding is performed, the welding part 701 has a structure in which nickel (Ni) and gold (Au) are further mixed with aluminium (Al).

Referring to the component analysis result of the welding portion 701, it can be confirmed that all components of aluminium, copper, and nickel, which were representative components, were well mixed and that the more the power of the laser welding was, the more well they were mixed.

**(Table 1)**

| Test sample | Measuring range | Component analysis result (unit: wt%) | | | | | | |
|---|---|---|---|---|---|---|---|---|
| | | C | O | Al | Ni | Cu | Au | P |
| 180W | AL Busbar | 18.3 | 8.3 | 73.3 | - | - | - | - |
| | Au plating section | - | 4.9 | 48.2 | 18.5 | 9.1 | 19.3 | - |
| | Copper foil | 16.9 | 1.0 | 29.8 | - | 52.4 | - | - |
| | Ni plating section | - | - | 38.4 | 51.2 | 5.9 | 0.4 | 4.1 |
| | Welding portion | - | 4.4 | 90.4 | 0.8 | 4.4 | - | - |
| 210W | AL Busbar | - | 4.3 | 91.7 | - | 4.1 | - | - |
| | Au plating section | - | - | 47.0 | 37.1 | 8.3 | 7.7 | - |
| | Copper foil | - | - | 35.1 | - | 64.9 | - | - |
| | Ni plating section | - | - | 36.0 | 53.3 | 5.6 | - | 5.1 |
| | Welding portion | - | 2.9 | 87.9 | 1.8 | 7.4 | - | - |
| 240W | AL Busbar | - | 6.4 | 89.7 | - | 4.0 | - | - |
| | Au plating section | - | - | 43.0 | 13.7 | 5.5 | 37.8 | - |
| | Copper foil | - | - | 38.1 | - | 61.9 | - | - |
| | Ni plating section | - | - | 36.5 | 51.3 | 6.3 | - | 5.9 |
| | Welding portion | - | 2.3 | 70.3 | 5.2 | 22.2 | - | - |

It can be confirmed that the metal components were well mixed in the welding portion 701, and there was no problem with the electrical characteristics, and the flexible printed circuit had sufficient tensile force, so the mechanical characteristics were also satisfied. The welding portion 701 may be formed using laser welding with an output of 1 kW or less, such as 180 W, 210 W, or 240 W.

In the first test sample, when the output of laser welding was 180 W, the thickness of the copper foil 501 was 35 µm, and the thickness of the aluminium tab 601 was 0.2 mm, the welding portion 701 included 90.4 wt% of aluminium, 0.8 wt% of nickel, 4.4 wt% of copper, and 4.4 wt% of oxygen.

In the second test sample, when the output of laser welding was 210 W, the thickness of the copper foil 501 was 35 µm, and the thickness of the aluminium tab 601 was 0.2 mm, the welding portion 701 included 87.9 wt% of aluminium, 1.8 wt% of nickel, 7.4 wt% of copper, and 2.9 wt% of oxygen.

In the third test sample, when the output of laser welding was 240 W, the thickness of the copper foil 501 was 35 µm, and the thickness of the aluminium tab 601 was 0.2 mm, the welding portion 701 included 70.3 wt% of aluminium, 5.2 wt% of nickel, 22.2 wt% of copper, and 2.3 wt% of oxygen.

When the output of laser welding was 180 to 240 W, the welding portion 701 included 70.3 to 90.4 wt% of aluminium, 0.8 to 5.2 wt% of nickel, 4.4 to 22.2 wt% of copper, and 2.3 to 4.4 wt% of oxygen.

Referring to the first to third test samples, because the aluminium tab 601, which is a thin medium of the same component as the bus bar 71, is applied to the copper foil 501 of 1 ounce, it is possible to weld the copper foil 501 to the aluminium bus bar 71.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

**<Description of symbols>**

| | | | |
|---|---|---|---|
| 10: | battery cells | 11, 12: | electrode terminal |
| 13: | vent | 20: | bus bar holder |
| 21: | bus bar support portion | 22: | vent portion |
| 40: | bus bar | 41: | terminal connection portion |
| 42: | sensing portion | 50: | flexible printed circuit (FPC) |
| 51: | copper foil | 52: | signal line |
| 53: | connection line | 54: | coating layer |
| 55: | slot hole | 56: | neck portion |
| 60: | aluminium tab | 70: | welding portion |
| 71: | bus bar | 72: | flexible printed circuit |
| 73: | copper foil | 74: | aluminium tab |
| 75: | adhesive layer | 76: | coating layer |
| 77: | 2-line beads | 501: | copper foil |
| 511: | nickel (Ni) plating section | 512: | gold (Au) plating section |
| 601: | aluminium tab | 701: | welding portion |
| L: | entire length | L1: | first length |
| L2: | second length | W: | width of neck portion |
| WL: | width of connection line | | |

## Claims

1. A rechargeable battery module comprising:
a plurality of battery cells stacked in a first direction;
a bus bar holder covering the battery cells while exposing electrode terminals of the battery cells in a third direction crossing a second direction at both sides in the second direction crossing the first direction;
a bus bar connecting the exposed electrode terminals to a bus bar support portion of the bus bar holder;
a flexible printed circuit (FPC) disposed on the bus bar on one surface of a copper foil exposed in the third direction;
an aluminium tab disposed on the other surface of the copper foil; and
a welding portion formed by the bus bar, the copper foil, and the aluminium tab that are laser welded.

2. The rechargeable battery module as claimed in claim 1, wherein
the copper foil has a thickness of 35 µm.

3. The rechargeable battery module as claimed in claim 1 or claim 2, wherein
the aluminium tab has a thickness of 0.1 to 0.2 mm.

4. The rechargeable battery module as claimed in any one of claims 1 to 3, wherein
the flexible printed circuit includes
a signal line for transmitting a sensing signal,
a connection line connecting the copper foil to the signal line,
a coating layer covering the signal line, the copper foil, and the connection line, and
a slot hole that surrounds an outer periphery of the copper foil and penetrates the coating layer to have both ends on both sides in a width direction of the connection line.

5. The rechargeable battery module as claimed in claim 4, wherein
the signal line is formed from one side of a width direction of the flexible printed circuit in a length direction of the flexible printed circuit,
while the copper foil is formed as a predetermined area on the other side of the width direction of the flexible printed circuit.

6. The rechargeable battery module as claimed in claim 5, wherein
the connection line is formed in the width direction to connect the signal line and the copper foil.

7. The rechargeable battery module as claimed in claim 6, wherein
the coating layer forms a neck portion between the slot holes on both sides of the connection line in the length direction.

8. The rechargeable battery module as claimed in claim 7, wherein
a width of the neck portion set in the length direction is set smaller than an entire length of the slot hole set in the length direction and larger than the width of the connecting line.

9. The rechargeable battery module as claimed in any one of claims 4 to 8, wherein
the bus bar includes
a terminal connection portion connecting electrode terminals of battery cells adjacent in the first direction, and
a sensing portion protruding in the second direction from one side of the terminal connection portion to be connected to the copper foil, optionally wherein:
the sensing portion has an area (L1*L2) of a first length (L1) in the first direction and a second length (L2) in the second direction, and supports an entire area of the copper foil, the slot hole, the connection line, and a part of the signal line.

10. The rechargeable battery module as claimed in any one of claims 1 to 9, wherein
the bus bar comprises aluminium, and the welding portion forms a structure in which aluminium of the bus bar, copper of the copper foil, and aluminium of the aluminium tab are mixed.

11. The rechargeable battery module as claimed in claim 10, wherein
the copper foil includes a nickel (Ni) plating section and a gold (Au) plating section.

12. The rechargeable battery module as claimed in claim 11, wherein
the welding portion forms a structure in which nickel (Ni) and gold (Au) are further mixed.

13. The rechargeable battery module as claimed in claim 12, wherein
the welding portion is formed with an output of 1 kW or less by the laser welding.

14. The rechargeable battery module as claimed in claim 12, wherein:
(i) when an output of the laser welding is 180 W, a thickness of the copper foil is 35 µm, and a thickness of the aluminium tab is 0.2 mm,
the welding portion includes 90.4 wt% of aluminium, 0.8 wt% of nickel, 4.4 wt% of copper, and 4.4 wt% of oxygen; or
(ii) when an output of the laser welding is 210 W, a thickness of the copper foil is 35 µm, and a thickness of the aluminium tab is 0.2 mm,
the welding portion includes 87.9 wt% of aluminium, 1.8 wt% of nickel, 7.4 wt% of copper, and 2.9 wt% of oxygen; or
(iii) when an output of the laser welding is 240 W, a thickness of the copper foil is 35 µm, and a thickness of the aluminium tab is 0.2 mm,
the welding portion includes 70.3 wt% of aluminium, 5.2 wt% of nickel, 22.2 wt% of copper, and 2.3 wt% of oxygen.

15. The rechargeable battery module as claimed in claim 12, wherein
the welding portion includes 70.3 to 90.4 wt% of aluminium, 0.8 to 5.2 wt% of nickel, 4.4 to 22.2 wt% of copper, and 2.3 to 4.4 wt% of oxygen.
